# FASCICULE DE BREVET EUROPEEN

(11) **EP 1 450 487 B1**
(45) Date de publication et mention de la délivrance du brevet: **11.04.2012**
(21) Numéro de dépôt: 04356011.9
(22) Date de dépôt: 10.02.2004
(51) Int. Cl.: H03K 17/082

(54) **Procédé et système de commande d'un transistor de puissance**
Verfahren und System zur Steuerung eines Leistungstransistors
System and method of controlling a power transistor

(30) Priorité: 10.02.2003 FR 0301551
(43) Date de publication de la demande: 25.08.2004
(73) Titulaire: Alstom, 92300 Levallois-Perret (FR)
(72) Inventeur: Lepage, Jean-Pierre, 65800 Aureilhan (FR)
(74) Mandataire: Myon, Gérard Jean-Pierre

(56) Documents cités:
- EP-A- 1 257 056
- US-A- 4 721 869
- US-A- 5 559 656
- US-A- 5 898 554
- US-B1- 6 275 093

## Description

L'invention concerne un procédé et un système de commande d'un composant électronique de puissance.

Plus précisément, l'invention concerne un procédé de commande contenant un processus de pilotage de l'ouverture et/ou de la fermeture du composant électronique de puissance, le processus de pilotage contenant plusieurs étapes pour commander l'application d'une succession de tensions de commutation différentes sur une électrode de commande dudit composant entre l'instant où débute le processus de pilotage et l'instant où doit s'achever l'ouverture et/ou la fermeture du composant électronique de puissance, le passage d'une étape à l'étape suivante dans ce processus de pilotage étant automatiquement réalisé dès qu'une condition de passage correspondante est satisfaite.

De tels procédés de commande sont connus sous les termes dé commande CATS et divulgués pour des transistors de puissance dans "Commande CATS : Evaluation de la Robustesse et Application à l'Asservissement de la Commande à la Fermeture", N. IDIR, H. SAWEZYN, J.J. FRANCHAUD, R. BAUSIERE, Université de Lille 1, Laboratoire L2EP.

Ces procédés de commande CATS ont été développés pour contrôler la dérivée di/dt de l'intensité du courant circulant entre le collecteur et l'émetteur du transistor de puissance ainsi que les variations de la dérivée dv/dt de la tension aux bornes du transistor de puissance.

Cet objectif est atteint en appliquant plusieurs tensions successives différentes entre le début et la fin du processus de commutation du transistor. Parmi cette succession de tensions, au moins une tension dite de freinage a une valeur intermédiaire différente de celles propres à maintenir le transistor de puissance dans les états passant et non passant. La valeur de cette tension de freinage est choisie de manière à freiner la commutation du transistor de puissance et, par là même, à limiter et contrôler les variations des dérivées di/dt et dv/dt respectivement lors de la fermeture et lors de l'ouverture du transistor de puissance. La durée pendant laquelle cette tension de freinage est appliquée sur l'électrode de commande du transistor de puissance doit être commandée avec précision pour limiter des pertes de commutation, c'est-à-dire la puissance consommée lors de chaque commutation. A cet effet, la fin de l'application de cette tension de freinage est automatiquement commandée lorsqu'une ou plusieurs conditions de passage sont satisfaites. Par exemple, dans le document précédent, la fin de l'application de la tension de freinage est automatiquement commandée si la tension aux bornes d'une diode montée en position antiparallèle par rapport au transistor de puissance est inférieure à un seuil prédéterminé et si la dérivée de cette même tension est inférieure à un autre seuil.

Toutefois, en cas de dysfonctionnement du transistor de puissance, la condition de passage pour commander la fin de l'application de la tension de freinage peut ne jamais se réaliser. Dans ces conditions, le procédé de commande reste bloqué, ce qui se traduit par le maintien de la tension de freinage sur l'électrode de commande du transistor de puissance pendant une durée indéterminée. Cette situation conduit, au mieux, à consommer inutilement de l'énergie et, au pire, à détériorer le transistor de puissance.

Une demande US 2002/0167826 a également proposé de surveiller la tension mode cathode d'un transistor IGBT pour identifier l'occurrence d'une désaturation et donc l'éventualité d'une dénaturation pour commander une réduction de la tension anode cathode selon une loi de variation temporelle prédéterminée. Comme pour les autres procédés connus, la désaturation peut très bien ne jamais intervenir alors même que le transistor IGBT connaît un dysfonctionnement.

L'invention vise à remédier à cet inconvénient en proposant un procédé de commande du type commande CATS d'un composant électronique de puissance dans lequel la consommation inutile d'énergie ou la détérioration du composant est évitée.

Elle a donc pour objet un procédé de commande tel que décrit ci-dessus, caractérisé en ce qu'il comporte les étapes consistant à :
- relever la valeur d'au moins un paramètre de fonctionnement caractéristique de la réaction du composant électronique de puissance en réponse à l'application successive desdites tensions de commutation,
- vérifier, grâce aux valeurs relevées, si cette réaction du composant électronique de puissance se produit dans un délai imparti prédéterminé,
- si oui, laisser ledit processus de pilotage se dérouler normalement,
   et
- sinon, interrompre ledit processus de pilotage et déclencher immédiatement un processus de sauvegarde de l'intégrité du composant électronique de puissance.

Dans le procédé ci-dessus, le temps de réaction du composant électronique de puissance, en réponse à l'application des tensions de commutation successives, est en permanence surveillé. Dès que ce temps de réaction dépasse un délai imparti prédéterminé, ce qui est le cas par exemple en cas de dysfonctionnement du composant électronique de puissance, le procédé interrompt le processus de pilotage de l'ouverture et/ou de la fermeture et active automatiquement un processus de sauvegarde. Dès lors, dans un tel procédé de commande, il est impossible que le processus de pilotage de chaque ouverture et/ou fermeture reste bloqué. La consommation d'énergie inutile ou la détérioration du composant électronique de puissance est donc évitée.

Suivant d'autres caractéristiques d'un procédé conforme à l'invention :
- au moins une condition de passage d'une étape à la suivante dans ledit processus de pilotage est fonction des valeurs relevées pour ledit au moins un paramètre de fonctionnement, et, pour vérifier si la réaction du composant électronique de puissance se produit dans le délai imparti prédéterminé, le procédé comporte l'étape consistant à vérifier qu'au moins cette condition de passage est satisfaite avant que le délai imparti prédéterminé ne se soit écoulé ;
- le procédé comporte l'étape consistant à vérifier que toutes les conditions de passage entre lesdites plusieurs étapes dudit processus de pilotage sont satisfaites avant qu'un délai imparti prédéterminé commun à toutes ces conditions de passage ne se soit écoulé ;
- le délai commun est compté à partir de l'instant où débute l'exécution dudit processus de pilotage, et ce délai commun est représentatif d'un délai maximum pour réaliser la commutation du composant électronique de puissance ;
- l'un des paramètres de fonctionnement relevé est la tension V_{CE} entre les électrodes de collecteur et d'émetteur du composant électronique de puissance ;
- l'un des paramètres de fonctionnement relevé est la tension sur l'électrode de commande ;
- l'une des étapes dudit processus de pilotage consiste à commander l'application sur ladite électrode de commande d'une tension de freinage propre à freiner la commutation du composant électronique de puissance ;
- la valeur de la tension de freinage est strictement comprise entre les valeurs des tensions de maintien du composant électronique de puissance respectivement dans l'état fermé et dans l'état ouvert ;
- ledit processus de pilotage est un processus de pilotage de la fermeture du composant électronique de puissance et la condition de passage entre l'étape de commande de l'application d'une tension de freinage et l'étape suivante est satisfaite si la tension entre les électrodes de collecteur et d'émetteur est inférieure à un premier seuil prédéterminé ;
- le processus de pilotage de la fermeture du composant électronique de puissance débute par l'étape de commande de l'application de la tension de freinage ;
- ledit processus de pilotage est un processus de pilotage de l'ouverture du composant électronique de puissance et la condition de passage entre une étape précédente et l'étape de commande de l'application de la tension de freinage est satisfaite si la tension entre les électrodes de collecteur et d'émetteur est supérieure à un second seuil prédéterminé ;
- la valeur du second seuil correspond à la moitié de la tension à commuter ;
- ladite étape précédente est une étape de commande de l'application d'une tension de valeur strictement inférieure à celle de la tension de freinage ;
- dans le processus de pilotage de l'ouverture du composant électronique de puissance, la condition de passage entre l'étape de commande de l'application de la tension de freinage et une étape suivante est satisfaite si la tension entre les électrodes de collecteur et d'émetteur atteint un maximum.

L'invention a également pour objet un système de commande d'un composant électronique de puissance apte à exécuter un processus de pilotage de l'ouverture et/ou de la fermeture de ce composant, ledit processus de pilotage contenant plusieurs étapes pour commander l'application d'une succession de tensions de commutation différentes sur une électrode de commande du composant électronique de puissance entre l'instant où débute ledit processus de pilotage et l'instant où doit s'achever l'ouverture et/ou la fermeture du composant électronique de puissance, le passage d'une étape à l'étape suivante dans ce processus de pilotage étant automatiquement réalisé dès qu'une condition de passage correspondante est satisfaite,
caractérisé en ce que le système comporte un calculateur électronique apte à :
- relever la valeur d'au moins un paramètre de fonctionnement caractéristique de la réaction du composant électronique de puissance en réponse à l'application successive desdites tensions de commutation,
- vérifier, grâce aux valeurs relevées, si cette réaction du composant électronique de puissance se produit dans un délai imparti prédéterminé,
- si oui, laisser ledit processus de pilotage (50, 80) se dérouler normalement, et
- sinon, interrompre ledit processus de pilotage et déclencher immédiatement l'exécution d'un processus de sauvegarde de l'intégrité du composant électronique de puissance.

Suivant d'autres caractéristiques d'un système de commande conforme à l'invention :
- au moins une condition de passage d'une étape à la suivante dudit processus de pilotage est fonction des valeurs relevées pour ledit au moins un paramètre de fonctionnement, et, pour vérifier si la réaction du composant électronique de puissance se produit dans le délai imparti prédéterminé, le calculateur électronique est apte à vérifier qu'au moins une condition de passage est satisfaite avant qu'un délai imparti prédéterminé pour cette condition de passage ne se soit écoulé ;
- le calculateur électronique est apte à vérifier que toutes les conditions de passage entre lesdites étapes du processus de pilotage sont satisfaites avant qu'un délai imparti prédéterminé commun à toutes ces conditions de passage ne se soit écoulé.

L'invention a également pour objet un support d'enregistrement d'informations comportant des instructions pour l'exécution des étapes d'un procédé de commande d'un composant électronique de puissance conforme à l'invention, lorsque lesdites instructions sont exécutées par un calculateur électronique.

L'invention sera mieux comprise à la lecture de la description qui va suivre, donnée uniquement à titre d'illustration, et faite en se référant aux dessins, sur lesquels :
- la figure 1 est une illustration schématique de l'architecture d'un système conforme à l'invention ;
- la figure 2 est un organigramme d'un procédé de commande de l'ouverture d'un composant électronique de puissance conforme à l'invention ;
- les figures 3A et 3B sont des graphiques illustrant chacun l'évolution au cours du temps d'un paramètre de fonctionnement du composant électronique de puissance lors de l'application du procédé de la figure 2 ;
- la figure 4 est un organigramme d'un procédé de commande de la fermeture d'un composant électronique de puissance conforme à l'invention ; et
- les figures 5A et 5B sont des graphiques illustrant chacun l'évolution au cours du temps d'un paramètre de fonctionnement du composant électronique de puissance lors de l'application du procédé de la figure 4.

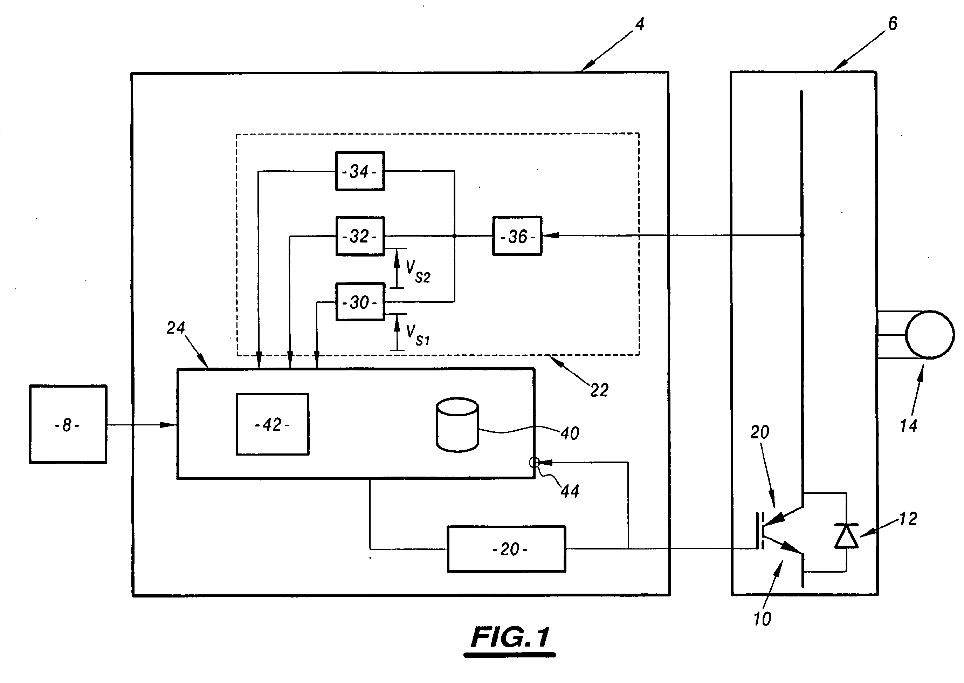

La figure 1 représente un allumeur électronique 4 propre à commander les transistors de puissance d'un dispositif de commutation électronique 6 en fonction de consignes transmises par un calculateur 8.

Le dispositif de commutation 6 est par exemple un onduleur triphasé conventionnel réalisé à partir de transistors 10 de puissance IGBT (Insulated Gate Bipolar Transistor) et de diodes 12 raccordées en position antiparallèle entre le collecteur et l'émetteur de chacun des transistors 10.

Le transistor 10 est typiquement capable de commuter des courants allant jusqu'à 1000 A et de supporter une tension V_{CE} entre le collecteur et l'émetteur à l'état non passant, c'est-à-dire à l'état ouvert, comprise entre 250 et 4000 V. A l'état passant, c'est-à-dire à l'état fermé, la tension V_{CE} est généralement inférieure à 5 V.

Ici, pour simplifier l'illustration, seul un de ces transistors 10 et une de ces diodes 12 sont représentés.

Cet onduleur triphasé 6 est par exemple destiné à alimenter une machine électrique tournante 14. Dans ces conditions, le calculateur 8 a pour fonction de délivrer à l'allumeur 4 des consignes de commande de la puissance développée par la machine 14, et l'allumeur a pour fonction de convertir ces consignes en des instructions de commande de chacun des transistors de puissance 10. Le procédé de conversion des consignes délivrées par le calculateur en des instructions de commande de chacun des transistors de puissance est classique et ne sera pas décrit ici.

Seuls les éléments de l'allumeur 4 nécessaires à la compréhension du nouveau système de commande décrit ici sont représentés sur la figure 1. De plus, le système de commande mis en oeuvre dans l'allumeur 4 étant le même pour chacun des transistors de puissance 10, seul le système de commande d'un des ces transistors de puissance sera décrit ici en détail.

L'allumeur 4 comporte une unité 20 de pilotage de la tension V_{GE} appliquée à la grille du transistor 10, un circuit 22 d'acquisition d'informations relatives à la tension V_{CE} entre le collecteur et l'émetteur du transistor 10, et une unité 24 de traitement logique propre, à partir des informations délivrées par le circuit 22, à commander l'unité de pilotage 20.

L'unité de pilotage 20 est propre à appliquer, sur la grille du transistor 10, quatre tensions différentes V₁₅, V₁₀, V₀ et V₋₁₀ correspondant respectivement à une tension de maintien du transistor dans l'état passant, de freinage de la commutation du transistor, de blocage du transistor et de maintien du transistor dans l'état non passant. Classiquement, les tensions V₁₅ et V₀ sont égales respectivement à + 15 V et 0 V. La valeur de la tension de freinage est, de préférence, strictement comprise entre celles des tensions V₀ et V₁₅ et par exemple choisie égale ici à 10 V.

La tension V₋₁₀ est propre à maintenir le transistor de puissance 10 dans l'état non passant, même si celle-ci est perturbée, par exemple à cause de perturbations électromagnétiques causées par la commutation d'autres transistors de puissance situés à proximité. A cet effet, sa valeur est choisie nettement inférieure à celle de la tension de blocage de manière à ce qu'une perturbation ne puisse pas modifier cette valeur pour la rendre supérieure à la tension de blocage, ce qui risquerait d'entraîner une commutation non commandée du transistor de puissance 10. Ici, cette valeur est choisie égale à -10V.

Le circuit 22 d'acquisition d'informations comporte trois circuits 30, 32 et 34 d'analyse d'informations relatives à la tension V_{CE} et un circuit 36 abaisseur de tension raccordé à l'entrée de chacun de ces trois circuits d'analyse.

Le circuit 36 est destiné à convertir la tension V_{CE} prélevée au collecteur du transistor 10 en une tension proportionnelle, mais comprise entre 0 et 5 V délivrée à l'entrée des trois circuits d'analyse 30 à 34.

Le circuit 30 est un comparateur analogique classique destiné à comparer la tension délivrée par le circuit 36 à un seuil S₁ et à délivrer le résultat de cette comparaison à l'unité de traitement logique 24. La valeur du seuil S₁ correspond ici à une valeur de la tension V_{CE} en-dessous de laquelle il est admis que le transistor 10 est dans l'état passant. La valeur de seuil S₁ est constante et choisie de préférence inférieure à 50 V et ici égale à 10 V.

Le circuit 32 est également un comparateur analogique conventionnel propre à comparer la tension délivrée par le circuit abaisseur 36 à un seuil S₂ et à délivrer le résultat de cette comparaison à l'unité de traitement logique 24. La valeur du seuil S₂ est, ici, constante et choisie pour correspondre sensiblement à la moitié de la tension V_{CE} à commuter. Ici, la valeur de S₂ est choisie égale à 500 V.

Le circuit 34 est propre à détecter le pic de tension V_{CE} qui se produit juste avant que le transistor 10 ait fini sa commutation vers l'état non passant et à délivrer à l'unité de traitement logique 24 cette information. Le circuit 34 est également réalisé de façon conventionnelle à l'aide, par exemple, de composants analogiques.

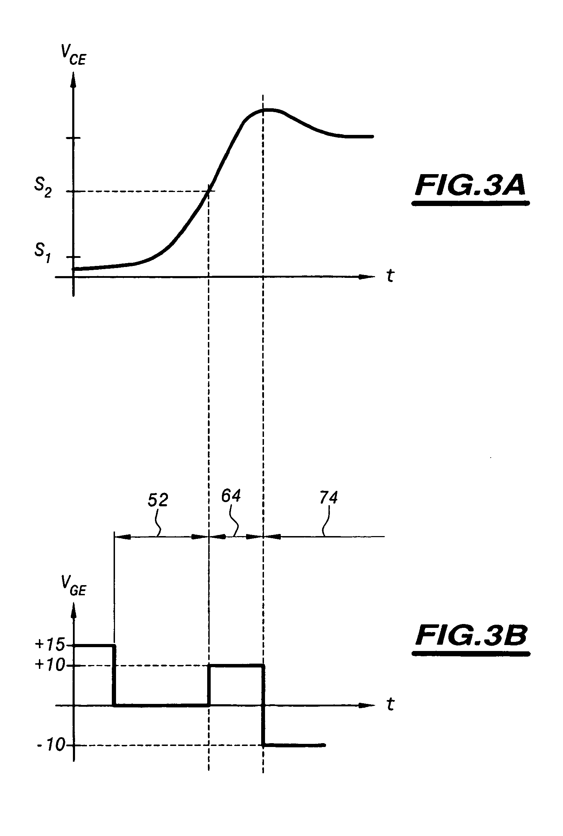

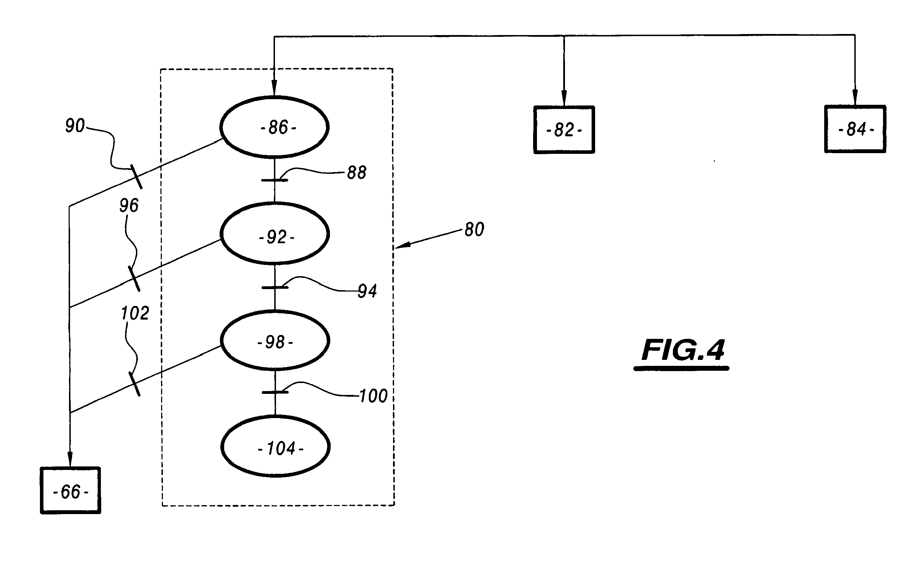

L'unité de traitement logique 24 est un calculateur électronique formant machine à états finis, capable de passer automatiquement d'un état de commande de l'unité de pilotage 20 à un autre lorsqu'une condition de passage à l'état suivant est satisfaite. L'unité de traitement logique 24 est ici apte à exécuter des instructions enregistrées sur un support d'enregistrement d'informations 40. Ce support d'enregistrement 40 contient ici des instructions pour l'exécution des étapes des procédés décrits ci-dessous en regard des figures 3 et 4.

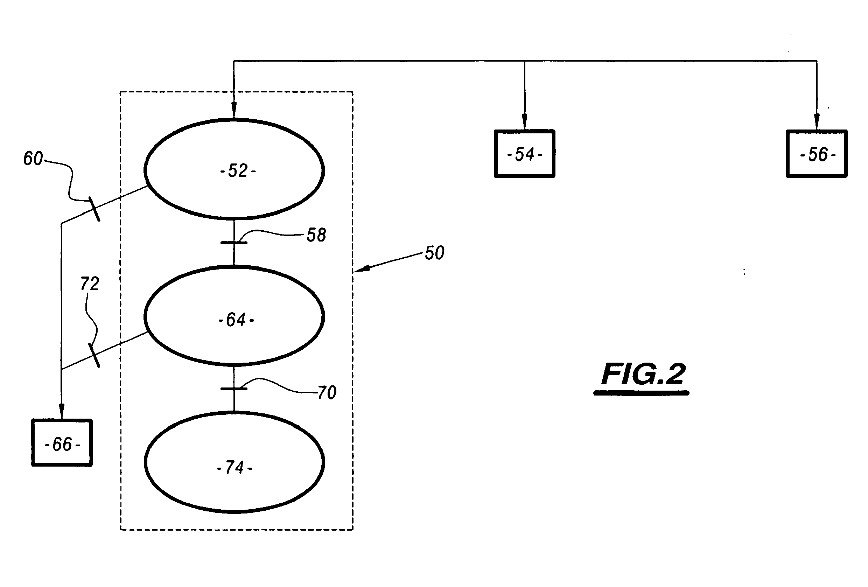

De plus, sur ce support d'enregistrement d'informations 40, sont également enregistrés les paramètres nécessaires au déroulement des procédés des figures 2 et 4 et notamment deux constantes T_{MAX OUVERTURE} et T_{MAX FERMETURE} correspondant aux délais maximum pour respectivement passer de l'état non passant à l'état passant et vice-versa.

Avantageusement et de manière à présenter une bonne insensibilité aux perturbations du milieu ambiant, l'unité de traitement logique 24 est un composant CPLD (Complex Programable Logid Device) programmé dans un langage VHDL (Very High Descriptive Language).

L'unité de traitement logique 24 comporte, de plus, un compteur de temps 42 propre à être déclenché au début de chaque commutation du transistor 10 et une entrée 44 pour relever la tension V_{GE} sur la grille du transistor 10.

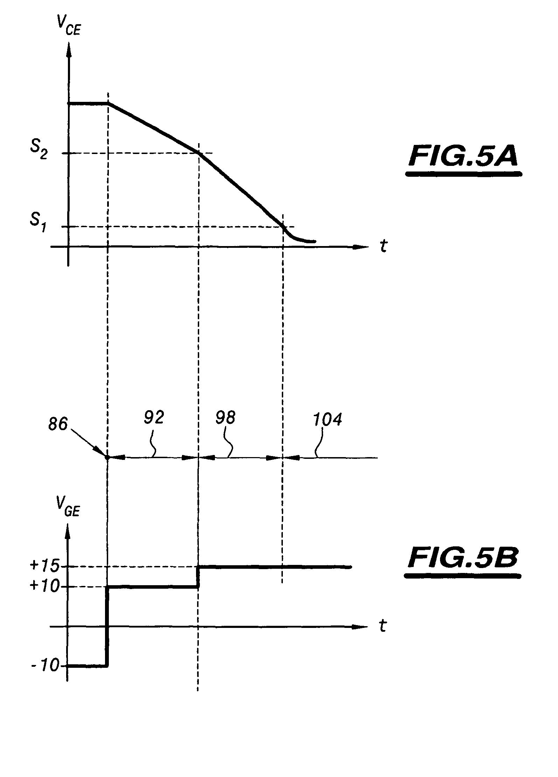

Le fonctionnement de l'allumeur 4 va maintenant être décrit, d'abord dans le cas de la commande de l'ouverture du transistor 10 en regard des figures 2, 3A et 3B, et ensuite dans le cas de la commande de la fermeture du transistor 10 en regard des figures 4, 5A et 5B.

L'unité de traitement logique 24 déclenche un processus 50 de pilotage de l'ouverture du transistor 10 à un instant déterminé, par exemple, en fonction des consignes transmises par le calculateur 8.

Simultanément, l'unité de traitement logique 24 active, à l'étape 54, le compteur de temps 42 et relève en permanence, lors de l'étape 56, les informations transmises par le circuit d'acquisition 22 et la tension V_{GE}.

Le processus 50 vise à freiner l'ouverture du transistor 10 pour contrôler les variations de la dérivée dV_{CE}/dt.

L'évolution de la tension V_{CE} et de la tension V_{GE} lors du déroulement normal du processus 50 sont représentées respectivement sur les figures 3A et 3B. Sur ces graphiques, l'échelle du temps a été divisée en trois périodes correspondant chacune aux étapes du processus 50 et portant donc les mêmes numéros.

Le processus 50 débute par une étape 52 lors de laquelle l'unité de traitement logique 24 commande l'unité de pilotage 20 pour que celle-ci applique la tension de blocage V₀ sur la grille du transistor 10.

Lors de cette étape, la tension V_{GE} est donc normalement nulle et la tension V_{CE} doit commencer à croître. Cette étape s'achève automatiquement quand une des deux conditions de passage 58 ou 60 est satisfaite.

La condition de passage 58 est satisfaite lorsque le comparateur 32 indique à l'unité de traitement logique 24 que la tension V_{CE} est supérieure au seuil S₂. Si cette condition 58 est satisfaite avant la condition de passage 60, l'unité de traitement logique procède automatiquement à l'étape 64.

La condition de passage 60 est satisfaite dès que le compteur de temps 42 indique que la durée T_{MAX OUVERTURE} s'est écoulée. Si cette condition de passage 60 est satisfaite avant la condition de passage 58, alors le processus de pilotage 50 est interrompu et un processus de sauvegarde 66 est activé.

A l'étape 64, l'unité de traitement logique commande l'unité de pilotage 20 pour que celle-ci applique sur la grille du transistor 10 la tension de freinage V₁₀. Ainsi, lors de cette étape 64, la tension V_{GE} doit normalement être égale à 10 V et la tension V_{CE} doit continuer à croître.

L'étape 64 s'achève dès que l'une des conditions de passage 70 ou 72 est réalisée.

La condition de passage 70 est satisfaite lorsque le circuit 34 délivre à l'unité de traitement logique 24 une information selon laquelle la tension V_{CE} a atteint son maximum, c'est-à-dire la point où la dérivée s'annule. Si cette condition 70 est satisfaite avant la condition 72, l'unité de traitement logique procède automatiquement à l'étape 74 du processus 50.

La condition de passage 72 est satisfaite dès que le compteur de temps indique que le temps écoulé depuis le début du processus 50 est supérieur à la durée T_{MAX OUVERTURE}. Si cette condition de passage 72 est satisfaite avant la condition 70, l'unité de traitement logique 24 procède automatiquement et immédiatement à l'interruption du processus 50 et à l'exécution du processus 66 de sauvegarde.

A l'étape 74, l'unité de traitement logique commande l'unité de pilotage 20 pour que celle-ci applique la tension V₋₁₀ sur la grille du transistor 10 pour maintenir le transistor 10 dans l'état non passant.

Après l'étape 74, le processus 50 s'achève, puisque la commutation du transistor 10 est finie. L'unité de traitement logique commande alors le maintien de la tension V₋₁₀ tant qu'un nouvel ordre de commutation n'est pas reçu.

Lors du processus de sauvegarde 66, l'unité de traitement logique 24 commande l'unité de pilotage 20 pour que celle-ci applique immédiatement la tension V₁₀ de maintien du transistor 10 dans l'état non passant. De plus, une défaillance de commutation à l'ouverture est signalée, par exemple, au calculateur 8, pour que, éventuellement, des traitements particuliers de cette information soient entrepris.

La figure 4 représente le procédé de commande de la fermeture du transistor 10.

L'unité de traitement logique 24 déclenche un processus 80 de pilotage de la fermeture du transistor 10 à un instant déterminé, par exemple, en fonction des consignes transmises par le calculateur 8.

Simultanément, l'unité de traitement logique 24 active, à l'étape 82, le compteur de temps 42 et relève en permanence, à l'étape 84, les informations relatives à la tension V_{CE} transmises par le circuit d'acquisition 22 et la tension V_{GE}.

Le processus 80 vise à freiner la fermeture du transistor 10 pour contrôler les variations de la dérivée di_{E}/dt du courant circulant dans le transistor 10. L'évolution de la tension V_{CE} et de la tension V_{GE} lors du déroulement normal du processus 80 sont représentées respectivement sur les figures 5A et 5B.

Sur ces graphiques, l'échelle du temps a été divisée en trois périodes correspondant chacune aux étapes du processus 80 et portant donc les mêmes numéros.

Le processus 80 débute par une étape 86 de commande de l'application de la tension de freinage V₁₀.

L'étape 86 s'achève dès que l'une des conditions de passage 88 ou 90 est satisfaite. Cette étape étant normalement très courte par rapport aux autres, elle a été représentée par un point sur les figures 5A, 5B.

La condition de passage 88 est satisfaite dès que la tension V_{GE} relevée par l'unité de traitement logique 24 est supérieure ou égale à 10 V. Si la condition de passage 88 est satisfaite avant la condition de passage 90, l'unité de traitement logique 24 procède automatiquement à l'étape 92 de maintien d'une tension V_{GE} égale à 10 V.

Lors de l'étape 92, la tension V_{GE} est donc normalement égale à 10 V et la tension V_{CE} commence à diminuer.

L'étape 92 s'achève dès qu'une condition de passage 94 ou 96 est satisfaite. La condition de passage 94 est ici satisfaite dès que le comparateur analogique 32 indique à l'unité de traitement logique 24 que la tension V_{CE} est inférieure au seuil S₂. Si la condition de passage 94 est satisfaite avant la condition 96, l'unité de traitement logique 24 procède automatiquement à une étape 98 de commande de l'unité de pilotage 20 pour que celle-ci applique sur la grille 10 la tension V₁₅ de maintien du transistor 10 dans l'état passant.

L'étape 98 s'achève dès qu'une condition de passage 100 ou 102 est satisfaite. La condition de passage 100 est ici satisfaite dès que la tension V_{CE} est inférieure au seuil S₁. Si la condition de passage 100 est satisfaite avant la condition 102, l'unité de traitement logique 24 procède alors automatiquement à l'étape 104 de commande du maintien de la tension V₁₅ sur la grille du transistor 10. Le processus 80 de pilotage est fini.

Les transitions 90, 96 et 102 sont automatiquement satisfaites dès que le compteur de temps 42 indique que le temps écoulé depuis le début du processus 80 est supérieur à la durée T_{MAX FERMETURE}. Si l'une de ces conditions est satisfaite, alors que l'une des étapes 86, 92 ou 98 ne s'est pas encore achevée, l'unité de traitement logique 24 interrompt le processus 80 et débute immédiatement l'exécution du processus 66 de sauvegarde décrit en regard de la figure 2.

Il est important de noter que, dans le mode de réalisation décrit ici, l'unité de traitement logique 24, en plus d'exécuter des processus de pilotage pour freiner l'ouverture et la fermeture du transistor 10, surveille en permanence le bon déroulement temporel de ces processus. En particulier, ici, l'unité de traitement logique 24 surveille si les conditions de passage d'une étape à la suivante dans les processus de pilotage sont réalisées dans un délai prédéterminé correspondant à une durée maximale pour que le processus de pilotage soit terminé. Dès lors que l'unité de traitement logique 24 constate que toutes les étapes du processus de pilotage n'ont pas été réalisées dans le délai imparti, il interrompt ce processus de pilotage et exécute immédiatement un processus de sauvegarde 66. Ainsi, le procédé décrit ci-dessus évite tout blocage du processus de pilotage.

Les valeurs des seuils pour les processus de pilotage de l'ouverture et de la fermeture du transistor 10 ont été choisies identiques. En variante, les valeurs des seuils pour le processus de pilotage de l'ouverture du transistor 10 sont différentes de celles pour le pilotage de la fermeture.

## Revendications

1. Procédé de commande d'un composant électronique de puissance (10) contenant un processus de pilotage (50, 80) de l'ouverture et/ou de la fermeture de ce composant, le processus de pilotage comprenant plusieurs étapes pour :
- commander l'application d'une succession de tensions de commutation différentes sur une électrode de commande dudit composant entre l'instant où débute le processus de pilotage et l'instant où doit s'achever l'ouverture et/ou la fermeture du composant électronique de puissance, le passage d'une étape à l'étape suivante dans ce processus de pilotage étant automatiquement réalisé dès qu'une condition de passage correspondante est satisfaite,
- relever (en 56 ; en 84) la valeur d'au moins un paramètre de fonctionnement caractéristique de la réaction du composant électronique de puissance (10) en réponse à l'application successive desdites tensions de commutation,
**caractérisé en ce qu'**il comprend les étapes consistant à :
- prédéterminer au moins un délai imparti (Tₘₐₓ ouverture, Tₘₐₓ fermeture),
- vérifier, grâce aux valeurs relevées, si cette réaction du composant électronique de puissance se produit dans le délai imparti prédéterminé,
- si oui, laisser (en 58, 70 ; 88, 94, 100) ledit processus de pilotage (50, 80) se dérouler normalement, et
- sinon, interrompre (en 60, 72 ; 90, 96, 102) ledit processus de pilotage et déclencher immédiatement un processus (66) de sauvegarde de l'intégrité du composant électronique de puissance (10).

2. Procédé selon la revendication 1, **caractérisé en ce qu'**au moins une condition de passage (58, 70 ; 88, 94, 100) d'une étape à la suivante dans ledit processus de pilotage est fonction des valeurs relevées pour ledit au moins un paramètre de fonctionnement, et **en ce que**, pour vérifier si la réaction du composant électronique de puissance se produit dans le délai imparti prédéterminé, le procédé comporte l'étape consistant à vérifier qu'au moins cette condition de passage est satisfaite avant que le délai imparti prédéterminé ne se soit écoulé.

3. Procédé selon la revendication 2, **caractérisé en ce que** le procédé comporte l'étape consistant à vérifier que toutes les conditions de passage (58, 70 ; 88, 94, 100) entre lesdites plusieurs étapes dudit processus de pilotage (50, 80) sont satisfaites avant qu'un délai imparti prédéterminé commun à toutes ces conditions de passage ne se soit écoulé.

4. Procédé selon la revendication 3, **caractérisé en ce que** le délai commun est compté à partir de l'instant où débute l'exécution dudit processus de pilotage (50, 80), et **en ce que** ce délai commun est représentatif d'un délai maximum pour réaliser la commutation du composant électronique de puissance, (10).

5. Procédé selon l'une quelconque des revendications 1 à 4, **caractérisé en ce que** l'un des paramètres de fonctionnement relevé est la tension (V_{CE}) entre les électrodes de collecteur et d'émetteur du composant électronique de puissance (10).

6. Procédé selon l'une quelconque des revendications précédentes, **caractérisé en ce que** l'un des paramètres de fonctionnement relevé est la tension (V_{GE}) sur l'électrode de commande.

7. Procédé selon l'une quelconque des revendications précédentes, **caractérisé en ce que** l'une des étapes (64 ; 92) dudit processus de pilotage consiste à commander l'application sur ladite électrode de commande d'une tension de freinage propre à freiner la commutation du composant électronique de puissance (10).

8. Procédé selon la revendication 7, **caractérisé en ce que** la valeur de la tension de freinage (V₁₀) est strictement comprise entre les valeurs des tensions de maintien du composant électronique de puissance respectivement dans l'état fermé (V₁₅) et dans l'état ouvert (V₋₁₀).

9. Procédé selon la revendication 7 ou 8, **caractérisé en ce que**, ledit processus de pilotage est un processus (80) de pilotage de la fermeture du composant électronique de puissance (10) et **en ce que** la condition de passage entre l'étape (92) de commande de l'application d'une tension de freinage et l'étape suivante est satisfaite si la tension (V_{CE}) entre les électrodes de collecteur et d'émetteur est inférieure à un premier seuil prédéterminé (S₂).

10. Procédé selon la revendication 9, **caractérisé en ce que** le processus (80) de pilotage de la fermeture du composant électronique de puissance (10) débute par l'étape (92) de commande de l'application de la tension de freinage.

11. Procédé selon l'une quelconque des revendications 7 à 10, **caractérisé en ce que**, ledit processus de pilotage est un processus (50) de pilotage de l'ouverture du composant électronique de puissance (10) et **en ce que** la condition de passage (58) entre une étape précédente et l'étape (64) de commande de l'application de la tension de freinage est satisfaite si la tension (V_{CE}) entre les électrodes de collecteur et d'émetteur est supérieure à un second seuil prédéterminé (S₂).

12. Procédé selon la revendication 11, **caractérisé en ce que** la valeur du second seuil (S₂) correspond à la moitié de la tension à commuter.

13. Procédé selon la revendication 11 ou 12, **caractérisé en ce que** ladite étape précédente est une étape (52) de commande de l'application d'une tension de valeur strictement inférieure à celle de la tension de freinage.

14. Procédé selon l'une quelconque des revendications 11 à 13, **caractérisé en ce que**, dans le processus (50) de pilotage de l'ouverture du composant électronique de puissance (10), la condition (70) de passage entre l'étape (64) de commande de l'application de la tension de freinage et une étape suivante (74) est satisfaite si la tension (V_{CE}) entre les électrodes de collecteur et d'émetteur atteint un maximum.

15. Système de commande d'un composant électronique de puissance apte à exécuter un processus de pilotage (50, 80) de l'ouverture et/ou de la fermeture de ce composant, ledit processus de pilotage contenant plusieurs étapes pour commander l'application d'une succession de tensions de commutation différentes sur une électrode de commande du composant électronique de puissance entre l'instant où débute ledit processus de pilotage et l'instant où doit s'achever l'ouverture et/ou la fermeture du composant électronique de puissance, le passage d'une étape à l'étape suivante dans ce processus de pilotage étant automatiquement réalisé dès qu'une condition de passage correspondante est satisfaite,
le système comportant un calculateur électronique (24) adapté pour :
- relever la valeur d'au moins un paramètre de fonctionnement caractéristique de la réaction du composant électronique de puissance (10) en réponse à l'application successive desdites tensions de commutation, **caractérisé en ce que** le calculateur électronique (24) est en outre adapté pour :
- enregistrer au moins un délai imparti prédéterminé (Tₘₐₓ ouverture, Tₘₐₓ fermeture),
- vérifier, grâce aux valeurs relevées, si cette réaction du composant électronique de puissance se produit dans le délai imparti prédéterminé,
- si oui, laisser ledit processus de pilotage (50, 80) se dérouler normalement, et
- sinon, interrompre ledit processus de pilotage (50, 80) et déclencher immédiatement l'exécution d'un processus (66) de sauvegarde de l'intégrité du composant électronique de puissance.

16. Système selon la revendication 15, **caractérisé en ce qu'**au moins une condition de passage d'une étape à la suivante dudit processus de pilotage est fonction des valeurs relevées pour ledit au moins un paramètre de fonctionnement, et **en ce que**, pour vérifier si la réaction du composant électronique de puissance (10) se produit dans le délai imparti prédéterminé, le calculateur électronique (24) est apte à vérifier qu'au moins une condition de passage est satisfaite avant qu'un délai imparti prédéterminé pour cette condition de passage ne se soit écoulé.

17. Système selon la revendication 16, **caractérisé en ce que** le calculateur électronique (24) est apte à vérifier que toutes les conditions de passage entre lesdites étapes du processus de pilotage sont satisfaites avant qu'un délai imparti prédéterminé commun à toutes ces conditions de passage ne se soit écoulé.

18. Support d'enregistrement d'informations comportant des instructions pour l'exécution des étapes d'un procédé de commande d'un composant électronique de puissance (10) conforme à l'une quelconque des revendications 1 à 14, lorsque lesdites instructions sont exécutées par un calculateur électronique (24).

## Claims

1. Process for controlling an electronic power component (10) comprising a process (50, 80) for piloting the opening and/or closure of the electronic power component, the piloting process comprising a plurality of steps for:
- controlling the application of a succession of different commutation voltages on a control electrode of said component between the instant when the piloting process begins and the instant when the opening and/or closure of the electronic power component must stop, the passage from one step to the following step in this piloting process being effected automatically as soon as a corresponding condition of passage is satisfied,
- reading (56; 84) the value of at least one operational parameter characteristic of the reaction of the electronic power component (10) in response to the successive application of said commutation voltages,
wherein it comprises the steps consisting in:
- predetermining at least one imparted time (Tₘₐₓ ouverture, Tₘₐₓ fermeture)
- verifying, thanks to the values read, whether this reaction of the electronic power component is produced in the predetermined imparted time,
- if so, allowing (58, 70; 88, 94, 100) said piloting process (50, 80) to continue normally, and
- if not, interrupting (60, 72; 90, 96, 102) said piloting process and immediately triggering off a process (66) for safeguarding the integrity of the electronic power component (10).

2. Process according to Claim 1, wherein at least one condition of passage (58, 70; 88, 94, 100) from one step to the following in said piloting process is a function of the values read for said at least one operational parameter and, in order to verify whether the reaction of the electronic power component is produced in the predetermined imparted time, the process comprises the step consisting in verifying that at least this condition of passage is satisfied before the predetermined imparted time has elapsed.

3. Process according to Claim 2, wherein the process comprises the step consisting in verifying that all the conditions of passage(58, 70; 88, 94, 100) between said plurality of steps of said piloting process (50, 80) are satisfied before a predetermined imparted time common to all these conditions of passage has elapsed.

4. Process according to Claim 3, wherein the common time is counted from the instant when the execution of said piloting process (50, 80) begins, and this common time is representative of a maximum time to effect commutation of the electronic power component (10).

5. Process according to any preceding Claim, wherein one of the operational parameters read is the voltage (V_{CE}) between the collector and emitter electrodes of the electronic power component (10),

6. Process according to any preceding Claim, wherein one of the operational parameters read is the voltage (V_{GE}) on the control electrode.

7. Process according to any preceding Claim, wherein one of the steps (64; 92) of said piloting process consists in controlling the application on said control electrode of a braking voltage adapted to brake commutation of the electronic power component (10).

8. Process according to Claim 7, wherein the value of the braking voltage (V₁₀) is strictly included between the values of the voltages for maintaining the electronic power component respectively in the closed state (V₁₅) and in the open state (V₁₀).

9. Process according to any of Claims 7 and 8, wherein said piloting process (80) is a process for piloting the closure of the electronic power component (10) and wherein the condition of passage between the step (92) of controlling the application of a braking voltage and the following step is satisfied if the voltage (V_{CE}) between the collector and emitter electrodes is less than a first predetermined threshold (S₂).

10. Process according to Claim 9, wherein the process (80) for piloting the closure of the electronic power component (10) begins by the step (92) of controlling the application of the braking voltage.

11. Process according to any of Claims 7 to 10, wherein said piloting process (50) is a process for piloting the opening of the electronic power component (10) and wherein the condition of passage (58) between a preceding step (64) and the step controlling the application of the braking voltage is satisfied if the voltage (V_{CE}) between the collector and emitter electrodes is higher than a second predetermined threshold (S₂).

12. Process according to Claim 11, wherein the value of the second threshold (S₂) corresponds to half the voltage to be commuted.

13. Process according to any of Claims 11 and 12, wherein said preceding step is a step (52) for controlling the application of a voltage of value strictly lower than that of the braking voltage.

14. Process according to any of Claims 11 to 13, wherein, in the process (50) for piloting the opening of the electronic power component (10), the condition (70) of passage between the step (64) controlling the application of the braking voltage and a following step (74) is satisfied if the voltage (V_{CE}) between the collector and emitter electrodes attains a maximum.

15. System for controlling an electronic power component adapted to execute a process (50, 80) for piloting the opening and/or closure of this component, said piloting process containing a plurality of steps for controlling the application of a succession of different commutation voltages on a control electrode of the electronic power component between the instant when said piloting process starts and the instant when the opening and/or closure of the electronic power component must finish, the passage from one step to the following step in this piloting process being automatically effected as soon as a corresponding condition of passage is satisfied,
the system comprising a computer (24) adapted to:
- read the value of at least one operational parameter characteristic of the reaction of the electronic power component (10) in response to the successive application of said commutation voltages,
wherein the computer (24) is also adapted to:
- record at least one predetermined imparted time (Tₘₐₓ ouverture, Tₘₐₓ fermeture),
- verify, thanks to the values read, whether this reaction of the electronic power component (10) is produced in the predetermined imparted time,
- if so, allow said piloting process (50, 80) to continue normally, and
- if not, interrupt said piloting process (50, 80) and immediately trigger off a process (66) for safeguarding the integrity of the electronic power component

16. System according to Claim 15, wherein at least one condition of passage from one step of said piloting process to the following is a function of the values read for said at least one operational parameter and wherein, in order to verify whether the reaction of the electronic power component (10) is produced in the predetermined imparted time, the computer (24) is adapted to verify that at least one condition of passage is satisfied before a predetermined time imparted for this condition of passage has elapsed.

17. System according to Claim 16, wherein the computer (24) is adapted to verify that all the conditions of passage between said plurality of steps of said piloting process are satisfied before a predetermined imparted time common to all these conditions of passage has elapsed.

18. Data recording support comprising instructions for the execution of the steps of the process for controlling an electronic power component (10) according to any of Claims 1 to 14, when said instructions are executed by a computer (24).

## Patentansprüche

1. Verfahren zur Steuerung eines elektronischen Leistungsschalters (10), das einen Prozess zur Regelung (50, 80) des Öffnens und/oder des Schließens dieses Schalters enthält, wobei der Regelungsprozess mehrere Schritte für Folgendes umfasst:
- Steuern des Anlegens einer Folge von unterschiedlichen Schaltspannungen an eine Steuerelektrode des Schalters zwischen dem Zeitpunkt, an dem der Regelungsprozess beginnt, und dem Zeitpunkt, an dem das Öffnen und/oder das Schließen des elektronischen Leistungsschalters enden soll, wobei der Übergang von einem Schritt zum folgenden Schritt in diesem Regelungsprozess automatisch ausgeführt wird, sobald eine entsprechende Übergangsbedingung erfüllt ist,
- Feststellen (in 56; in 84) des Werts von mindestens einem Betriebsparameter, der für die Reaktion des elektronischen Leistungsschalters (10) für das Ansprechen auf das aufeinanderfolgende Anlegen der Schaltspannungen kennzeichnend ist,
**dadurch gekennzeichnet, dass** es Schritte umfasst, die in Folgendem bestehen:
- Vorbestimmen mindestens einer festgesetzten Frist (Tₘₐₓ Öffnen, Tₘₐₓ Schließen),
- Überprüfen, ob diese Reaktion des elektronischen Leistungsschalters sich innerhalb der vorbestimmten festgesetzten Frist ereignet, mittels der festgestellten Werte,
- wenn ja, wird der Regelungsprozess (50, 80) normal ablaufen gelassen (in 58, 70; 88, 94, 100), und
- anderenfalls wird der Regelungsprozess unterbrochen (in 60, 72; 90, 96, 102) und sofort ein Prozess (66) zur Sicherung der Unversehrtheit des elektronischen Leistungsschalters (10) ausgelöst.

2. Verfahren nach Anspruch 1, **dadurch gekennzeichnet, dass** mindestens eine Bedingung für den Übergang (58, 70; 88, 94, 100) von einem Schritt zum nächsten in dem Regelungsprozess von den für den mindestens einen Betriebsparameter festgestellten Werten abhängig ist, und **dadurch**, dass der Prozess zum Überprüfen, ob die Reaktion des elektronischen Leistungsschalters sich innerhalb der vorbestimmten festgesetzten Frist ereignet, den Schritt umfasst, der darin besteht, zu überprüfen, dass mindestens diese Übergangsbedingung erfüllt wird, bevor die vorbestimmte festgesetzte Frist abgelaufen ist.

3. Verfahren nach Anspruch 2, **dadurch gekennzeichnet, dass** das Verfahren den Schritt umfasst, der darin besteht, zu überprüfen, dass alle Bedingungen für den Übergang (58, 70; 88, 94, 100) zwischen den mehreren Schritten des Regelungsprozesses (50, 80) erfüllt sind, bevor eine vorbestimmte festgesetzte Frist, die allen diesen Übergangsbedingungen gemein ist, abgelaufen ist.

4. Verfahren nach Anspruch 3, **dadurch gekennzeichnet, dass** die gemeinsame Frist ab dem Zeitpunkt beginnt, an dem die Ausführung des Regelungsprozesses (50, 80) beginnt, und **dadurch**, dass diese gemeinsame Frist für eine Höchstfrist zum Ausführen des Schaltens des elektronischen Leistungsschalters (10) charakteristisch ist.

5. Verfahren nach einem der Ansprüche 1 bis 4, **dadurch gekennzeichnet, dass** der eine der festgestellten Betriebsparameter die Spannung (V_{CE}) zwischen den Kollektor- und Emitterelektroden des elektronischen Leistungsschalters (10) ist.

6. Verfahren nach einem der vorhergehenden Ansprüche, **dadurch gekennzeichnet, dass** der eine der festgestellten Betriebsparameter die Spannung (V_{GF}) an der Steuerelektrode ist.

7. Verfahren nach einem der vorhergehenden Ansprüche, **dadurch gekennzeichnet, dass** der eine der Schritte (64; 92) des Regelungsprozesses im Steuern des Anlegens einer Bremsspannung, die dazu geeignet ist, das Schalten des elektronischen Leistungsschalters (10) zu bremsen, an die Steuerelektrode besteht.

8. Verfahren nach Anspruch 7, **dadurch gekennzeichnet, dass** der Wert der Bremsspannung (V₁₀) strikt zwischen den Werten der Haltespannungen des elektronischen Leistungsschalters im geschlossenen Zustand (V₁₅) beziehungsweise im offenen Zustand (V₁₀) enthalten ist.

9. Verfahren nach Anspruch 7 oder 8, **dadurch gekennzeichnet, dass** der Regelungsprozess ein Prozess (80) zur Regelung des Schließen des elektronischen Leistungsschalters (10) ist, und **dadurch**, dass die Bedingung für den Übergang zwischen dem Schritt (92) der Steuerung des Anlegens einer Bremsspannung und dem folgenden Schritt erfüllt ist, wenn die Spannung (V_{CE}) zwischen den Kollektor- und Emitterelektroden niedriger ist als ein erster vorbestimmter Schwellenwert (S₂).

10. Verfahren nach Anspruch 9, **dadurch gekennzeichnet, dass** der Prozess (80) zur Regelung des Schließen des elektronischen Leistungsschalters (10) mit dem Schritt (92) der Steuerung des Anlegens der Bremsspannung beginnt.

11. Verfahren nach einem der Ansprüche 7 bis 10, **dadurch gekennzeichnet, dass** der Regelungsprozess ein Prozess (50) zur Regelung des Öffnens des elektronischen Leistungsschalters (10) ist, und **dadurch**, dass die Bedingung für den Übergang (58) zwischen einem vorhergehenden Schritt und dem Schritt (64) des Steuerns des Anlegens der Bremsspannung erfüllt ist, wenn die Spannung (V_{CE}) zwischen den Kollektor- und Emitterelektroden höher ist als ein zweiter vorbestimmter Schwellenwert (S₂),

12. Verfahren nach Anspruch 11, **dadurch gekennzeichnet, dass** der Wert des zweiten Schwellenwerts (S₂) der Hälfte der zu schaltenden Spannung entspricht.

13. Verfahren nach Anspruch 11 oder 12, **dadurch gekennzeichnet, dass** der vorhergehende Schritt ein Schritt (52) zum Steuern des Anlegens einer Spannung ist, deren Wert strikt niedriger ist als derjenige der Bremsspannung.

14. Verfahren nach einem der Ansprüche 11 bis 13, **dadurch gekennzeichnet, dass** die Bedingung (70) für den Übergang zwischen dem Schritt (64) zum Steuern des Anlegens der Bremsspannung und einem folgenden Schritt (74) im Prozess (50) zur Regelung des Öffnens des elektronischen Leistungsschalters (10) erfüllt ist, wenn die Spannung (V_{CE}) zwischen den Kollektor- und Emitterelektroden einen Höchstwert erreicht.

15. System zum Steuern eines elektronischen Leistungsschalters, das in der Lage ist, einen Prozess zur Regelung (50, 80) des Öffnens und/oder des Schließens dieses Schalters auszuführen, wobei der Regelungsprozess mehrere Schritte enthält, um zwischen dem Zeitpunkt, an dem der Regelungsprozess beginnt, und dem Zeitpunkt, an dem das Öffnen und/oder das Schließen des elektronischen Leistungsschalters enden soll, das Anlegen einer Folge von unterschiedlichen Schaltspannungen an eine Steuerelektrode des elektronischen Leistungsschalters zu steuern, wobei der Übergang von einem Schritt zum folgenden Schritt in diesem Regelungsprozess automatisch ausgeführt wird, sobald eine entsprechende Übergangsbedingung erfüllt ist,
wobei das System einen Computer (24) umfasst, der für Folgendes angepasst ist:
- Feststellen des Werts von mindestens einem Betriebsparameter, der für die Reaktion des elektronischen Leistungsschalters (10) für das Ansprechen auf das aufeinanderfolgende Anlegen der Schaltspannungen kennzeichnend ist,
**dadurch gekennzeichnet, dass** der Computer (24) ferner für Folgendes angepasst ist:
- Speichern von mindestens einer vorbestimmten festgesetzten Frist (Tₘₐₓ Öffnen, Tₘₐₓ Schließen),
- Überprüfen, ob diese Reaktion des elektronischen Leistungsschalters sich innerhalb der vorbestimmten festgesetzten Frist ereignet, mittels der festgestellten Werte,
- wenn ja, wird der Regelungsprozess (50. 80) normal ablaufen gelassen, und
- anderenfalls wird der Regelungsprozess (50. 80) unterbrochen und sofort ein Prozess (66) zur Sicherung der Unversehrtheit des elektronischen Leistungsschalters ausgelöst.

16. System nach Anspruch 15, **dadurch gekennzeichnet, dass** mindestens eine Bedingung für den Übergang von einem Schritt des Regelungsprozesses zum nächsten von den für den mindestens einen Betriebsparameter festgestellten Werten abhängig ist, und **dadurch**, dass zum Überprüfen, ob die Reaktion des elektronischen Leistungsschalters (10) sich innerhalb der vorbestimmten festgesetzten Frist ereignet, der Computer (24) in der Lage ist, zu überprüfen, dass mindestens eine Übergangsbedingung erfüllt wird, bevor eine vorbestimmte festgesetzte Frist für diese Übergangsbedingung abgelaufen ist.

17. System nach Anspruch 16, **dadurch gekennzeichnet, dass** der Computer (24) in der Lage ist, zu überprüfen, dass alle Bedingungen für den Übergang zwischen den Schritten des Regelungsprozesses erfüllt werden, bevor eine vorbestimmte festgesetzte Frist, die allen diesen Übergangsbedingungen gemein ist, abgelaufen ist.

18. Informationsaufzeichnungsträger, der Befehle für die Ausführung der Schritte eines Verfahrens zur Steuerung eines elektronischen Leistungsschalters (10) nach einem der Ansprüche 1 bis 14 umfasst, wenn die Befehle durch einen Computer (24) ausgeführt werden.
